# EUROPEAN PATENT APPLICATION

(11) **EP 4 704 541 A1**
(43) Date of publication of application: **04.03.2026**
(21) Application number: 25196382.3
(22) Date of filing: 18.08.2025
(51) Int. Cl.: H10W 10/00, H10W 70/00, H10W 70/68, H10W 74/01, H10W 74/15, G02B 6/42, H10W 10/20

(54) **FAN-OUT PACKAGE INCLUDING A PHOTONIC INTEGRATED CIRCUIT**

(30) Priority: 30.08.2024 US 202418821077
(71) Applicant: Nokia Solutions and Networks Oy, 02610 Espoo (FI)
(72) Inventor: EL AMRANI, Abderrahim, Sunnyvale (US); MARININS, Aleksandrs, Mountain View (US)
(74) Representative: Nokia EPO representatives

(57) **Abstract**

A method is provided for fabricating a chip package comprising one or more chips including a photonic integrated circuit (PIC) comprising one or more optical modulators. The method includes forming a redistribution layer (RDL). The method also includes forming a dam on a bonding side of the RDL. The method also includes arranging the one or more chips on the bonding side of the RDL and bonding the one or more chips to the RDL. The dam surrounds an empty space between the RDL and the one or more optical modulators. The method also includes dispensing underfill material between at least some of the one or more chips and the RDL. The dam prevents the underfill material from entering the empty space between the RDL and the one or more optical modulators.

## Description

Various exemplary embodiments disclosed herein relate to packaging of electronics chips, especially to fan-out wafer-level packaging (FOWLP) and fan-out panel-level packaging (FOPLP), of electronics chips, and more particularly to a method for FOWLP or FOPLP of one or more photonic integrated chips.

### BACKGROUND

FOWLP and FOPLP are emerging advanced packaging techniques in the electronics chip industry for forming single system-in-package modules. They encompass two main branches: techniques in which a redistribution layer (RDL) is built first (RDL-first) and techniques in which the RDL is built last (RDL-last). In RDL-first, RDL build-up processing is done on a temporary carrier, and integrated circuits (ICs) are assembled by flip-chip attachment and are molded. In RDL-last, ICs are bonded to a temporary carrier and molded, then either transferred onto a second carrier (face down process) or ground down (face up process) to expose pads for RDL processing. These processes aim to achieve high I/O interconnect counts and improved performance at lower costs compared to technologies like 2.5D interposer and conventional flip-chip BGA (ball grid array). Electrical interconnects primarily utilize IC pads, copper pillars, RDL layers, and BGAs.

While FOWLP or FOPLP have been used for assembling electronics chips in mobile and computing products, the techniques faces challenges in accommodating photonics products. For instance, the typical molding of ICs may be incompatible with photonic ICs (PICs) as they require optical interfaces for light coupling. Additionally, in an RDL-first approach, flip-chip assembly involving underfill can harm the optical interfaces as well as the optical devices due to contamination or RF performance degradation, leading to optical coupling loss. The underfill material, e.g. a curable liquid polymer, may have undesired optical properties, but can nevertheless be used to strengthen assemblies against mechanical/thermal shock, vibration humidity and any chemical corrosives that might damage the solder joins.

Photonic ICs may include devices such as modulators for light control and optical facets for light coupling. They tend to be highly sensitive to optically unfriendly materials such as underfill compounds. These materials can significantly impact device performance by distorting the interfacial optical field. Contaminants like underfill, with a relatively high index of refraction, can pose a significant risk as they can penetrate optically sensitive regions and degrade optical performance. This unpredictability in performance degradation can lead to unacceptable variations among units of the same product.

Photonic ICs with optically sensitive devices may be negatively impacted by flip-chip assembly because of the underfill material that comes to proximity of the optically sensitive devices. In a flip-chip ball grid array (FCBGA) package, a cavity in the substrate or a cut-out can be used to enable the flip-chip of a photonic chip. However, when transitioning to a more advanced packaging technology such as fan-out WLP, there a critical need for a solution to this problem.

### SUMMARY

The scope of protection sought for various embodiments of the invention is set out by the independent claims. The embodiments and features, if any, described in this Specification that do not fall under the scope of the independent claims are to be interpreted as examples useful for understanding various embodiments of the invention.

According to embodiments of the present invention, a method for fabricating a chip package comprising one or more chips including a photonic integrated circuit (PIC) comprising one or more optical modulators, includes steps of forming a redistribution layer (RDL), forming a dam on a bonding side of the RDL, and arranging the one or more chips on the bonding side of the RDL and bonding the one or more chips to the RDL. The dam preferably surrounds an empty space between the RDL and the one or more optical modulators. The method includes dispensing underfill material between at least some of the one or more chips and the RDL. The dam prevents the underfill material from entering the empty space between the RDL and the one or more optical modulators. The term "bonding side" means a side of the RDL on which the one or more chips are arranged. The bonding side may be a top side or a bottom side of the RDL.

The dam may be formed integrally with the RDL, *i.e.* as part of the RDL. The dam may protrude beyond a mainly planar surface of the RDL. In this disclosure, the term "photonic integrated circuit" may refer to any integrated circuit that comprises one or more photonic elements. For example, the PIC may include electronic circuitry configured to interact with the optical modulators, as well as other electronic circuitry that is not necessarily related to the optical modulators.

The one or more chips may include several PICs. In one embodiment, a respective region of the empty space is located between the RDL and each respective PIC. In another embodiment, several empty spaces are provided for the PICs. In one embodiment, a respective empty space is located between the RDL and one or more optical modulators of each respective PIC.

In some embodiments, further chips may be bonded to the RDL on the bonding side or on the other side of the RDL.

According to some embodiments, the method may include a step of forming a cavity in a polyimide layer on a frontside surface of the PIC which is shaped to receive at least a portion of a rim of the dam.

The frontside surface of the first chip means a face of the PIC that is oriented toward the RDL. The one or more chips (including the PIC) may be arranged on a top side of the RDL. In this case, the frontside surface of the first chip will face downward, and the rim of the dam is a top portion of the dam. Alternatively, the one or more chips (including the PIC) may be arranged on a bottom side of the RDL. In this case, the frontside surface of the first chip will face upward, and the rim of the dam is a bottom portion of the dam.

According to some embodiments, the method may include a step of forming a piece that comprises the RDL and the dam prior to arranging the one or more chips on the bonding side of the RDL.

According to some embodiments, the dam is formed by a semi-additive build-up process. According to some embodiments, the dam is formed by electroplating of a metal. The metal may be copper or nickel, for example, or an alloy comprising copper or nickel, or another metal or alloy. According to some embodiments, the dam is formed from a thick polyimide layer using photolithography.

The polyimide layer may be thick in the sense that it has a thickness similar to the height of the dam. The photolithography process removes polyimide from selected regions of the polyimide layer while preserving polyimide at least in a region of the dam. The dam is thus formed from the polyimide layer by removal of polyimide from regions adjoining the dam.

According to some embodiments, forming the RDL includes forming a second dam in a position on the RDL to prevent underfill material from flowing into an area adjacent to an optical input/output (I/O) facet of the first chip.

According to some embodiments, the bonding side of the RDL is a bottom side of the RDL, and the method includes molding one or more further chips, forming the RDL and the dam on a bottom side of the one or more further chips after the molding, and flip-chip bonding the one or more chips, including the PIC, to the RDL.

In this embodiment, there are at least two groups of chips: a first group including the one or more further chips, arranged on a top side of the RDL; and a second group, including the one or more chips (including the PIC), arranged on a bottom side of the RDL.

"Molding" a chip (or a group of chips) is a process in which a liquid casting material (e.g. a compound material) is admitted into a space surrounding the chip (or the group of chips), thus encapsulating or coating the chip (or the group of chips). In at least one embodiment, the one or more further chips comprise a radio-frequency (RF) integrated circuit (IC) and an application-specific integrated circuit (ASIC).

According to embodiments of the present invention, a chip package includes one or more chips, including a photonic integrated circuit (PIC) comprising one or more optical modulators; and a redistribution layer (RDL). The one or more chips are arranged on a bonding side of the RDL and are bonded to the RDL. An underfill layer formed by an underfill material is deposited between the one or more chips and the RDL. The underfill layer comprises an empty space between the RDL and the one or more optical modulators.

The empty space is a space that does not contain any of the underfill material. The empty space may contain air, for example, or some residual gas that may remain in the empty space after production. Absence of underfill material in the empty space can minimize spurious effects of the underfill material on the light propagating in the one or more modulators, effects that may be due to direct or indirect electromagnetic interactions between the underfill material and the light in the one or more modulators. In an embodiment, the one or more optical modulators comprise one or more Mach-Zehnder (MZ) interferometers. The one or more MZ interferometers may extend parallel to a frontside surface of the PIC.

According to some embodiments, the chip package can include a dam arranged at least partly in the underfill layer. The dam provides at least part of a boundary of the empty space in the underfill layer.

The filling material is located on the outer side of the dam. The empty space is located on an inner side of the dam. The dam thus separates the empty space from the filling material. The boundary of the empty space in the underfill layer may be a circumference of the empty space in the underfill layer. In one embodiment, the dam extends along the whole circumference of the empty space. In this case, the dam fully surrounds the empty space in the underfill layer.

According to some embodiments, the chip package further comprises a cavity formed in a polyimide layer on a frontside surface of the PIC, with the cavity being shaped to receive a rim of the dam. The rim of the dam is a top portion of the dam when the chip package is oriented such that the dam extends vertically upward from the RDL.

According to some embodiments, the dam is formed mainly of copper, nickel, or polyimide.

In one embodiment, all chips are on the first side (e.g. top side) of the RDL.

According to some embodiments, the chip package includes a mold compound encapsulating one or more of the one or more chips. According to some embodiments, the mold compound does not encapsulate the PIC, and wherein the PIC is flip-chip bonded to the RDL.

In another embodiment, the PIC is on a second side (e.g. bottom side) of the RDL.

According to some embodiments, the chip package comprises one or more additional chips arranged on a first side of the RDL, the bonding side being a second side of the RDL.

In one embodiment, the first side is a top side of the RDL while the second side (i.e. the bonding side) is a bottom side of the RDL.

According to some embodiments, the chip package includes a mold compound encapsulating one or more of the one or more further chips.

According to some embodiments, in the chip package, the PIC is flip-chip bonded to the RDL.

In some embodiments, the one or more chips, or the one or more further chips, include at least one of a radio-frequency (RF) integrated circuit (IC) and an application-specific integrated circuit (ASIC).

Other aspects in accordance with the invention will become apparent from the following detailed description, taken in conjunction with the accompanying drawings, illustrated by way of example of the principles of the invention.

### BRIEF DESCRIPTION OF DRAWINGS

Embodiments of the present invention are illustrated by way of example with reference to the accompanying drawings Figures (Figs. or FIGS.), which should not be construed to limit the present disclosure.
Figure 1(a) illustrates an RDL-first fan-out package.
Figure 1 (b) illustrates an RDL-first fan-out package having an underfill dam according to embodiments of the present invention.
Figures 2(a) and (b) are cross-sectional side views of a molded chip package according to embodiments of the present invention.
Figures 3(a) and (b) are cross sectional side views of embodiments the invention in other configurations.

### DETAILED DESCRIPTION

The following descriptions are presented to enable any person skilled in the art to create and use apparatuses, systems and methods described herein. It will be readily understood that the components of the embodiments as generally described herein and illustrated in the appended figures could be arranged and designed in a wide variety of different configurations. Thus, the following more detailed description of various embodiments, as represented in the figures, is not intended to limit the scope of the present disclosure, but is merely representative of various embodiments. While the various aspects of the embodiments are presented in drawings, the drawings are not necessarily drawn to scale unless specifically indicated.

Reference throughout this specification to "one embodiment," "an embodiment," or similar language means that a particular feature, structure, or characteristic described in connection with the indicated embodiment is included in at least one embodiment of the present invention. Thus, the phrases "in one embodiment," "in an embodiment," and similar language throughout this specification may, but do not necessarily, all refer to the same embodiment independently of or combined with any other aspect of the disclosure. For example, an apparatus may be implemented or a method may be practiced using any number of the aspects set forth herein. In addition, the scope of the disclosure is intended to cover such an apparatus or method which is practiced using other structure, functionality, or structure and functionality in addition to or other than the various aspects of the disclosure set forth herein. It should be understood that any aspect of the disclosure disclosed herein may be embodied by one or more elements of a claim.

According to embodiments of the invention, mechanical dam structures may be used to prevent contaminants from reaching any optically sensitive region. A main dam structure may be fabricated when building the redistribution layers (RDL) in a FOWLP or FOPLP. According to embodiments, it is also possible to include a complementary cavity on the chip side to form an improved sealing structure. The dam structures provided to be protective against contamination by any substance, whether of liquid or solid type, that is introduced by flip-chip processing.

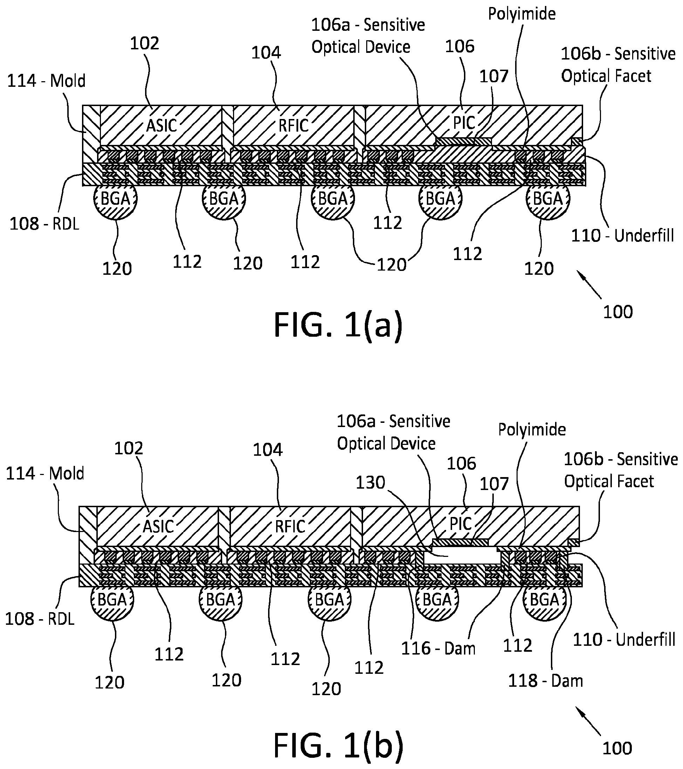

In embodiments of the invention, the main physical dam structure is preferably fabricated as part of the RDL process within the RDL-first-fan-out process. Figures 1(a) and (b) illustrate an RDL-first fan-out package without (Fig. 1(a)) and with the use of an underfill dam (Fig. 1(b)).

Figure 1(a) is a cross-sectional side view of a molded chip package 100, which includes an ASIC 102, an RFIC 104 and a photonic IC (PIC) 106, bonded with an RDL 108 by a flip-chip process with underfill material 110, and having a ball grid array (BGA) 120 provided at the bottom surface of the packaging to establish electrical connections between the chips and a printed circuit board (PCB)(not shown). The underfill material 110 may be an epoxy resin dispensed between each die and the RDL 108 to fill the gap around the solder bumps 112 electrically connecting each of the chips 102, 104, 106 with the RDL. The underfill material is then cured, providing mechanical support, enhancing thermal conductivity, and protecting against environmental stresses. An additional layer of encapsulant, such as a molding compound 114, may be applied over the dies embedding the dies and the RDL and providing further protection.

The PIC 106 includes one or more optical components 106a. The one or more optical components include at least an optical modulator 107, which may include Mach-Zehnder (MZ) interferometers or the like. The PIC 106 may further include optical inputs/outputs (I/O) 106b, such as waveguides, at the facet. Optical waveguides are used to guide light signals through the PIC, and can be made of silicon, silicon nitride (SiN), or other materials with suitable optical properties. Electromagnetic coupling between modulators or other optical components and the underfill material can negatively affect the optical output of the optical modulators or other components.

As shown, the underfill material 110 fills in the gap under all the chips including the areas under the optical components 106a and the optical I/O 106b. The underfill material can contaminate and reduce the optical capabilities of the waveguides and other sensitive optical components of the PIC.

In order to prevent this result and to protect optically sensitive areas, according to embodiments of the invention, dams may be formed to guide the underfill material and to create an empty space under optical components.

Figure 1(b) is a cross-sectional side view of a molded chip package 100 according to embodiments of the present invention. In this example, two dams 116, 118 are formed during the fabrication of the RDL, preferably, integrally with the RDL, *i.e.,* as part of the RDL. It is known that processes like photolithography, sputtering, and electroplating may be used to pattern the RDL. The first dam 116 may be formed during the RDL process on the top of the RDL 108 so as to surround the sensitive optical components 106a of the PIC 106 when it is mounted on the RDL 108 and to prevent the optical components 106a from being contaminated by underfill material. The dam 116 itself can be any shape (e.g., rectangular, circular, oval, etc.) so long as it directs the underfill material precisely away from the area under the sensitive optical components 106a preventing contamination of those components. As mentioned above, the dam 116 preferably surrounds an empty space 130, or void, under (or over is PIC is flipped) the optical components 106a and may be integrally formed with the RDL.

Since the dams are formed during the RDL process, each dam is preferably fabricated using material that is used during the RDL process, such as copper electroplating, thick photosensitive polyimide (e.g., if lithography is used), or nickel. The skilled person would understand that other materials can be used protect the sensitive optical components. An optical modulator is an example of sensitive optical component to be protected by a dam formed during the RDL fabrication process.

The filling material is located on an outer side of the dam. The empty space is located on an inner side of the dam. The dam thus separates the empty space from the filling material. The boundary of the empty space in the underfill layer may be a circumference of the empty space in the underfill layer. In one embodiment, the dam extends along the whole circumference of the empty space. In this case, the dam fully surrounds the empty space in the underfill layer.

A second dam 118 may be formed in a similar manner as dam 116 so as to prevent underfill material from contaminating the optical I/O 106b of the PIC 106, which are typically formed at an edge area of the chip, as an optical facet.

Since it is difficult to control the size of a dam to a single micron, the seal between a dam (i.e., the rim portion of the dam formed during the RDL process) and the respective chip may be improved by providing a complementary structure on the chip side. According to embodiments of the present invention, on the bottom side of PIC 106, a cavity can be created during the lithography of the passivation photosensitive polyimide layer, which is typically deposited on the bottom side of the PIC. The cavity helps the dam form a better seal against underfill material to prevent leakage toward the empty space adjacent optical components. During the Flip-chip process, the dam(s) and cavity(s) are preferably designed in a way so that the corresponding dam falls within the corresponding cavity creating a good seal against underfill material.

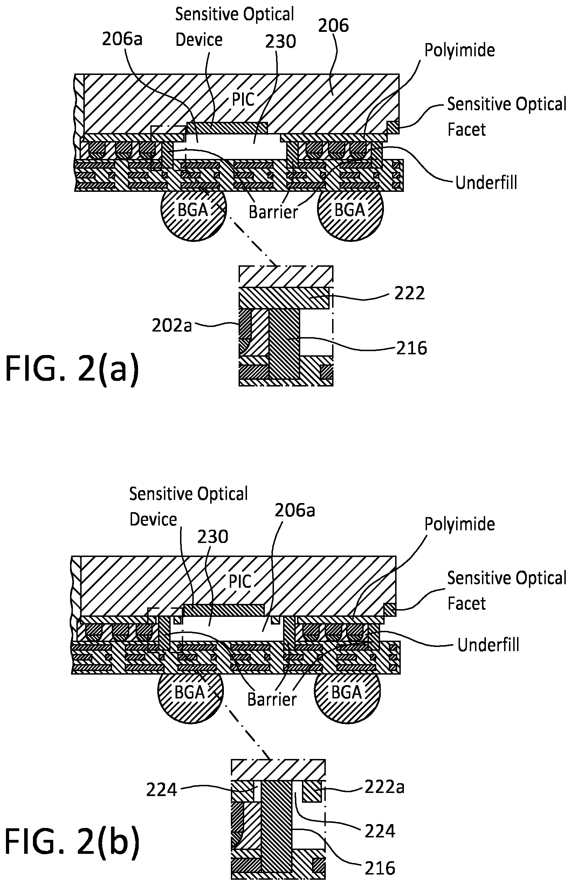

Figures 2(a) and (b) are cross-sectional side views of a molded chip package 200 according to embodiments of the present invention, which show a dam structure (a) without and (b) with the use of a complementary cavity on the chip side.

Referring to Figure 2(a), dam 216 directly contacts the polymide layer 222 on the bottom of PIC 206. This is shown better in a zoomed call out 200a. As shown in Figure 2(b), a cavity 224 has been formed in the polymide layer 222, e.g., by photolithography or etching, to expose the chip die 206 around the area below the optical components 206a. This is shown better in a zoomed call out 200b.

It should be understood that shown is merely a cross section, and the dam 216 should completely surround the area below the optical components 206a so that an empty space 230 may be formed. As described above, the dam can be any shape, and therefore, it would be understood that the cavity 224 should have a shape that matches the shape of dam 216. As shown, a portion of the polymide layer 222a could be left between the cavity 224 and the area 206a under the PIC where the polymide layer has already been removed. By allowing the dam 216 to make direct contact with the die, a better seal can be formed to ensure protection of sensitive optical components from contamination from underfill material. The cavity 224 can be formed during the fabrication process of the PIC.

In another embodiment, the molded package may incorporate all other ICs except the PIC using an RDL-last fan-out approach, where the RDL processing occurs post-molding of the ICs, followed by the formation of the main dam structure. The PIC is interconnected to the other ICs and package via the flip-chip process, including underfilling, with the dam serving a protective function.

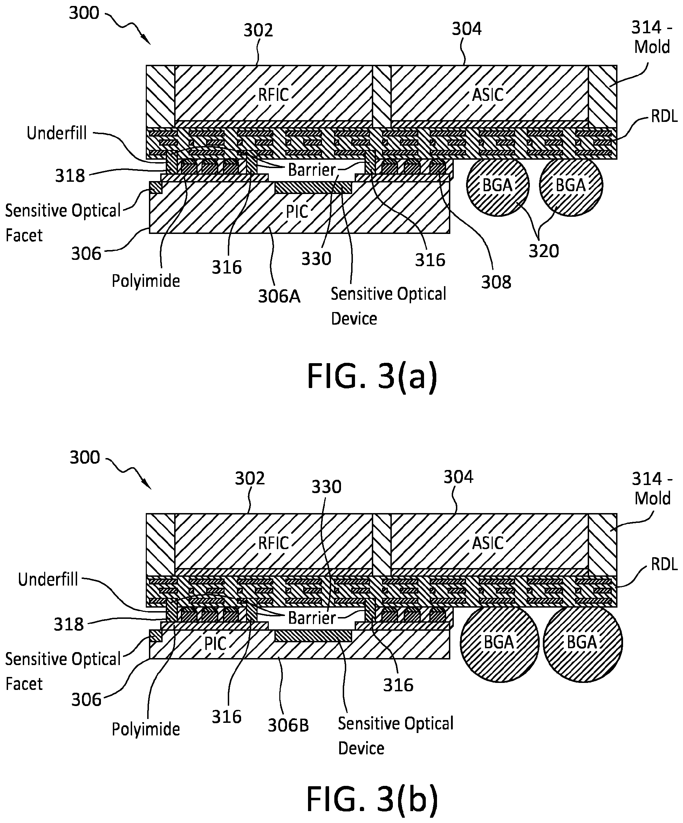

Figures 3(a) and (b) show a cross-sectional side view of embodiments of the invention in two configurations. A first configuration is illustrated in Figure 3(a). Chip package 300, according to an embodiment, includes an RFIC 302, an ASIC 304, and a PIC 306A, which in this case is full thickness, and the PIC 306A's protrusion is accommodated on the module PCB with a cavity or a cut-out (not shown). A second configuration, shown in Fig. 3(b), uses a thinned PIC 306B to fit within a gap created by the BGAs (as shown to the left of the BGAs).

According to embodiments of the invention, the dams 316 (surrounding empty space 330) and 318 are formed on the bottom of the RDL 308 of the molded IC package 300; PIC 306A or B is then bonded to the bottom of the RDL 308, as shown in both Figures 3(a) and (b). Since the PIC 306 is on the bottom of the RDL 308 and the BGA 320 is fabricated to the thickness of the PIC 306, depending on the thickness of the PIC 306, a cavity or cut out may be used on the PCB side (not shown) to accommodate the PIC 306. This process is otherwise the same as the processes of Figure 1(b) or Figures 2(a) and 2(b).

According to some embodiments, the chips may include several PICs. In one embodiment, a respective region of the empty space may be located between the RDL and each respective PIC. In another embodiment, several empty spaces can be provided for the PICs. In one embodiment, a respective empty space may be located between the RDL and one or more optical modulators (or other optical components) of each respective PIC.

In some embodiments, further chips may be bonded to the RDL on the bonding side or on the other side of the RDL.

According to some embodiments, the method may include a step of forming a cavity in a polyimide layer on a frontside surface of the PIC which is shaped to receive at least a portion of a rim of the dam.

The frontside surface of the first chip means a face of the PIC that is oriented toward the RDL. The one or more chips (including the PIC) may be arranged on a top side of the RDL. In this case, the frontside surface of the first chip will face downward, and the rim of the dam is a top portion of the dam. Alternatively, the one or more chips (including the PIC) may be arranged on a bottom side of the RDL. In this case, the frontside surface of the first chip will face upward, and the rim of the dam is a bottom portion of the dam.

According to some embodiments, the method may include a step of forming a piece that comprises the RDL and the dam prior to arranging the one or more chips on the bonding side of the RDL.

According to some embodiments, the dam is formed by a semi-additive build-up process. According to some embodiments, the dam is formed by electroplating of a metal. The metal may be copper or nickel, for example, or an alloy comprising copper or nickel, or another metal or alloy. According to some embodiments, the dam is formed from a thick polyimide layer using photolithography.

The polyimide layer may be thick in the sense that it has a thickness similar to the height of the dam. The photolithography process removes polyimide from selected regions of the polyimide layer while preserving polyimide at least in a region of the dam. The dam is thus formed from the polyimide layer by removal of polyimide from regions adjoining the dam.

According to some embodiments, forming the RDL includes forming a second dam in a position on the RDL to prevent underfill material from flowing into an area adjacent to an optical input/output (I/O) facet of the first chip.

According to some embodiments, the bonding side of the RDL is a bottom side of the RDL, and the method includes molding one or more further chips, forming the RDL and the dam on a bottom side of the one or more further chips after the molding, and flip-chip bonding the one or more chips, including the PIC, to the RDL.

In this embodiment, there are at least two groups of chips: a first group including the one or more further chips, arranged on a top side of the RDL; and a second group, including the one or more chips (including the PIC), arranged on a bottom side of the RDL.

"Molding" a chip (or a group of chips) is a process in which a liquid casting material (e.g. a compound material) is admitted into a space surrounding the chip (or the group of chips), thus encapsulating or coating the chip (or the group of chips). In at least one embodiment, the chips comprise may include radio-frequency (RF) integrated circuit (IC) and/or an application-specific integrated circuit (ASIC).

According to embodiments of the present invention, a chip package includes one or more chips, including a photonic integrated circuit (PIC) comprising one or more optical modulators and a redistribution layer (RDL). The chips may be arranged on a bonding side of the RDL and are bonded to the RDL. An underfill layer formed by an underfill material is deposited between the one or more chips and the RDL. The underfill layer comprises an empty space between the RDL and the one or more optical modulators.

According to the invention, the empty space does not contain any of the underfill material, but the empty space may contain air, for example, or some residual gas that may remain in the empty space after production. Absence of underfill material in the empty space can minimize spurious effects of the underfill material on the light propagating in the one or more modulators, effects that may be due to direct or indirect electromagnetic interactions between the underfill material and the light in the one or more modulators.

The skilled person should understand that the present invention with or without the complementary cavity structure, forms a distinctive mechanical damming structure, is compatible with existing RDL processes, and can be implemented scalably and at low cost.

Although specific embodiments of the invention have been described and illustrated, the invention is not to be limited to the specific forms or arrangements of parts so described and illustrated. The scope of the invention is to be defined by the claims appended hereto and their equivalents.

### List of abbreviations

The following abbreviations were used herein and are given the following meanings: ASIC: Application Specific Integrated Circuit
UF: Underfill
FCBGA: Flip-Chip Ball Grid Array
FO: Fan-Out
FOPLP: Fan-Out Panel-Level Packaging
FOWLP: Fan-Out Wafer-Level Packaging
I/O: Input/Output
IC: Integrated Circuit,
PIC: Photonic Integrated Circuit
PLP: Panel-Level Packaging
RDL: Redistribution Layer
RFIC: Radio Frequency Integrated Circuit
WLP: Wafer-Level Packaging

In this description, numerous details are set forth for the purpose of explanation. However, one of ordinary skill in the art will realize that the invention may be practiced without the use of these specific details. In other instances, well-known structures and processes are shown in block diagram form in order not to obscure the description of the invention with unnecessary detail. Thus, the present disclosure is not intended to be limited to the embodiments shown, but is to be accorded the widest scope consistent with the principles and features disclosed herein.

In describing exemplary embodiments, specific terminology is used for the sake of clarity. For purposes of description, each specific term is intended to at least include all technical and functional equivalents that operate in a similar manner to accomplish a similar purpose. Additionally, in some instances where a particular exemplary embodiment includes a plurality of system elements, device components or method steps, those elements, components or steps may be replaced with a single element, component or step. Likewise, a single element, component or step may be replaced with a plurality of elements, components or steps that serve the same purpose. Moreover, while exemplary embodiments have been shown and described with references to particular embodiments thereof, those of ordinary skill in the art will understand that various substitutions and alterations in form and detail may be made therein without departing from the scope of the invention. Further still, other embodiments, functions and advantages are also within the scope of the invention. In the claims, reference signs in parentheses are provided to facilitate a mapping between features of the claims and elements of the drawings; such reference signs shall not be construed as limiting the claims.

Embodiments 16 and 17 defined below correspond to claims 16 and 17 of the priority application.

Embodiment 16. The chip package as recited in claim 15 (see below), comprising a mold compound (314) encapsulating one or more (302, 304) of the one or more further chips.

Embodiment 17. The chip package of embodiment 16, wherein the PIC (306) is flip-chip bonded to the RDL (308).

## Claims

1. A method for fabricating a chip package (100) comprising one or more chips (102, 104, 106; 306A; 306B) including a photonic integrated circuit (PIC) (106) comprising one or more optical modulators (107), wherein the method comprises:
forming a redistribution layer (RDL) (108);
forming a dam (116; 216; 316) on a bonding side of the RDL;
arranging the one or more chips on the bonding side of the RDL and bonding the one or more chips to the RDL, wherein the dam surrounds an empty space (130; 230; 330) between the RDL and the one or more optical modulators; and
dispensing underfill material (110) between at least some of the one or more chips and the RDL;
wherein the dam prevents the underfill material from entering the empty space between the RDL and the one or more optical modulators.

2. The method as recited in claim 1, further comprising a step of forming a cavity (224) in a polyimide layer (222) on a frontside surface of the PIC which is shaped to receive at least a portion of a rim of the dam.

3. The method as recited in claim 1, comprising:
forming a piece that comprises the RDL and the dam prior to arranging the one or more chips on the bonding side of the RDL.

4. The method as recited in claim 1, wherein the dam is formed by a semi-additive build-up process.

5. The method as recited in claim 1, wherein the dam is formed by electroplating of a metal.

6. The method as recited in claim 1, wherein the dam is formed from a thick polyimide layer using photolithography.

7. The method as recited in claim 1, wherein forming the RDL comprises forming a second dam (118) in a position on the RDL to prevent underfill material from flowing into an area adjacent to an optical input/output (I/O) facet (106b) of the first chip.

8. The method as recited in claim 1, wherein the bonding side of the RDL is a bottom side of the RDL, and wherein the method comprises:
molding one or more further chips (302, 304);
forming the RDL and the dam on a bottom side of the one or more further chips after said molding; and
flip-chip bonding the one or more chips, including the PIC, to the RDL.

9. A chip package (100), comprising:
one or more chips (102, 104, 106; 306A; 306B), including a photonic integrated circuit (PIC) (106; 306) comprising one or more optical modulators (107);
a redistribution layer (RDL) (108; 308), wherein the one or more chips are arranged on a bonding side of the RDL and are bonded to the RDL; and
an underfill layer comprising an underfill material (110) deposited between the one or more chips and the RDL;
wherein the underfill layer comprises an empty space (130; 230; 330) between the RDL and the one or more optical modulators.

10. The chip package of claim 9, comprising:
a dam (116; 216; 316) arranged at least partly in the underfill layer, the dam providing at least part of a boundary of the empty space in the underfill layer.

11. The chip package as recited in claim 10, further comprising a cavity (224) formed in a polyimide layer (222) on a frontside surface of the PIC, said cavity containing at least a portion of a rim of the dam.

12. The chip package as recited in claim 10, wherein the dam is formed mainly of copper, nickel, or polyimide.

13. The chip package as recited in claim 9, comprising a mold compound (114) encapsulating one or more of the one or more chips.

14. The chip package as recited in claim 13, wherein the mold compound does not encapsulate the PIC, and wherein the PIC is flip-chip bonded to the RDL.

15. The chip package as recited in claim 9, wherein the chip package (300) comprises one or more further chips (302, 304) arranged on a first side of the RDL, the bonding side being a second side of the RDL (308).
